# EUROPEAN PATENT APPLICATION

(11) **EP 4 697 891 A1**
(43) Date of publication of application: **18.02.2026**
(21) Application number: 25190865.3
(22) Date of filing: 22.07.2025
(51) Int. Cl.: H10D 64/00, H10D 30/62, H10D 64/27, H10D 64/01

(54) **LDMOS TRANSISTOR IN A SEMICONDUCTOR FIN**

(30) Priority: 15.08.2024 US 202418805607
(71) Applicant: NXP B.V., 5656 AG Eindhoven (NL)
(72) Inventor: Dinh, Viet Thanh, 5656AG Eindhoven (NL); Perera, Asanga H, 5656AG Eindhoven (NL); Xie, Juan, 5656AG Eindhoven (NL); Wong, Alden C, 5656AG Eindhoven (NL)
(74) Representative: Colaiuda, Antonella

(57) **Abstract**

A transistor, such as an LDMOS transistor, includes a drift region located in a carrier path in semiconductor fin between a channel region and a drain region. The transistor includes two gate dielectric structures covering different locations of the semiconductor fin. A thinner gate dielectric structure covers a portion of the channel region directly below the gate of the transistor. The thicker dielectric structure covers a portion of the drift region located directly below the gate. A transition region between the channel region and the drift region in the semiconductor fin is located directly under the gate.

## Description

### BACKGROUND OF THE INVENTION

### Field of the Invention

This invention relates in general to transistors with a drift region in a semiconductor fin.

### Description of the Related Art

An LDMOS (laterally diffused metal oxide semiconductor) transistor is a Field Effect Transistor (FET) that includes a source region, drain region, channel region, gate, and drift region. The drift region is located in a carrier path (e.g., holes, electrons) between the channel region and the drain region for providing the FET with a higher breakdown voltage than a FET without a drift region. The drift region is of the same net conductivity doping type as the source region and the drain region.

### BRIEF DESCRIPTION OF THE DRAWINGS

The present invention may be better understood, and its numerous objects, features, and advantages made apparent to those skilled in the art by referencing the accompanying drawings.
Figure 1 is a 3-D view of a transistor according to at least one embodiment of the present invention.
Figures 2 is a partial top view of a wafer during a stage in manufacture according to at least one embodiment of the present invention.
Figures 3-16 set forth partial cross-sectional side views at different locations of a semiconductor wafer during stages of its manufacture according to at least one embodiment of the present invention.

The use of the same reference symbols in different drawings indicates identical items unless otherwise noted. The figures are not necessarily drawn to scale.

### DETAILED DESCRIPTION

The following sets forth a detailed description of at least one mode for carrying out the invention. The description is intended to be illustrative of the invention and should not be taken to be limiting.

As disclosed herein, a transistor, such as an LDMOS transistor, includes a drift region located in a carrier path in semiconductor fin between a channel region and a drain region. The transistor includes two gate dielectric structures covering different locations of the semiconductor fin. A thinner gate dielectric structure covers a portion of the channel region directly below the gate of the transistor. The thicker dielectric structure covers a portion of the drift region located directly below the gate. A transition region between the channel region and the drift region in the semiconductor fin is located directly under the gate.

In one embodiment, providing a gate structure located directly over both a drift region and channel region in a semiconductor fin where a portion of the drift region directly under the gate is covered by a thicker gate dielectric and a portion of the channel region located directly under the gate is covered by a thinner gate dielectric may improve the performance of the LDMOS transistor implemented in a FinFET CMOS process. Such a transistor may have a good radio-frequency (RF) performance, with a higher cutoff frequency (Ft), due to a shorter channel length and lower parasitic capacitances without compromising on the reliability and breakdown voltages.

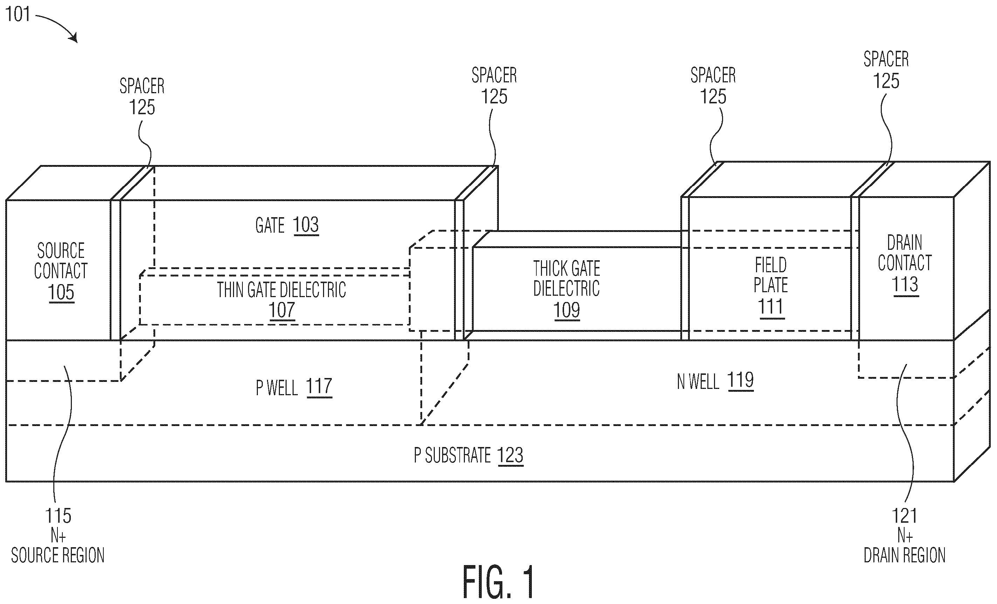

Figure 1 is a 3-D view of an LDMOS transistor 101 implemented in a semiconductor fin according to at least one embodiment of the present invention. In some embodiments, transistor 101 is implemented in an integrated circuit (not shown in Figure 1). The integrated circuit may include multiple FinFET transistors in multiple semiconductor fins of the integrated circuit. Presently, FinFETs are being utilized in the manufacture of integrated circuits at the most advanced semiconductor manufacturing nodes. In some embodiments, the processes described herein can be used to make an LDMOS transistor in an integrated circuit with other FinFETs at these advanced nodes, thereby allowing for LDMOS transistors to be implemented in integrated circuits with the most advanced technology.

Transistor 101 includes a source contact 105, gate 103, field plate 111, and drain contact 113. Dielectric spacers 125 are located on two sides of gate 103 and field plate 111. Transistor 101 includes a carrier path located in a semiconductor fin (not shown in Figure 1) that extends laterally in locations covered by the source contact 105, gate 103, field plate 111, and drain contact 113. When in a conductive state, the carrier path conveys carriers (e.g., holes for P-type devices, electrons for N-type devices) from the source region (covered by source contact 105) through a channel region (covered by gate 103), through a drift region (covered by thick gate dielectric 109 and field plate 111) to the drain region (covered by drain contact 113). In Figure 1, the semiconductor fin is covered by a thin gate dielectric 107 at some locations covered by gate 103 and is covered by a thick gate dielectric 109 at other locations covered by gate 103, at locations covered by field plate 111, and at locations between gate 103 and field plate 111.

The portion of the semiconductor fin covered by source contact 105, N+ source region 115, the portion of the semiconductor fin covered by drain contact 113, and N+ drain region 121 each have a relatively high net N-type conductivity doping concentration of N-type dopants (e.g., of arsenic, phosphorus). In one embodiment, the net N type doping concentration of these regions is 5e19 to 1e21 per cm³, but may be of other concentrations in other embodiments.

P well 117 and N well 119 are located over base P substrate region 123. P well 117 and the portion of the semiconductor fin located directly over P well 117 between source contact 105 and the portion of the semiconductor fin located directly under N well 119 each have a net P-type conductivity doping (e.g., Boron). In some embodiments, the doping concentration of P well 117 and the above described portion of the fin are in the range of 1-10e17 per cm³, but may be of other concentrations in other embodiments. The portion of semiconductor fin having a net P-type doping concentration covered by gate 103 serves as the channel region for transistor 101.

N well 119 and the portion of the semiconductor fin located directly over N well 119 each have a net N-type doping concentration of 1-10e17 per cm³, but may be of other concentrations in other embodiments. This doping concentration is less than the doping concentrations of the source and drain regions. This portion of the semiconductor fin having an N type doping concentration located between the P-type channel region and the drain region serves as the drift region for transistor 101.

In some embodiments, providing a drift region including a portion located directly under the gate increases the reliability of the transistor (due to the electric field modulation by the field plate) and reduces the overlapping capacitance of the transistor (due to a thicker gate dielectric and the separation of the capacitance contribution from the field plate to the gate). In some embodiments, the implementation of a separate field plate 111 helps to modulate the electric field by reducing the peak field to make it more uniform, or spread the field into a deeper region away from the surface, which improves reliability. Since the field plate is separated from the gate, it does not contribute to the total gate capacitance of the device, which helps to reduce the capacitance. Moreover, in this region, a thicker gate oxide is used, instead of a thin oxide, which may help to further reduce the overlap capacitance between the drain to the channel.

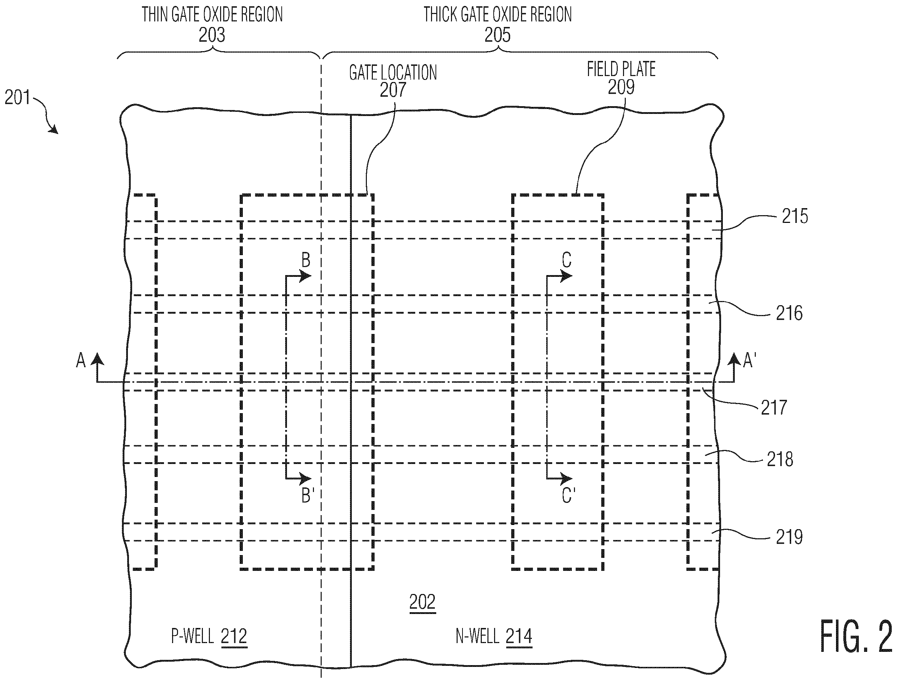

Figure 2 is a partial top view of a semiconductor wafer 201 on which an LDMOS transistor will be subsequently formed according to at least one embodiment of the present invention. Wafer 201 includes a substate 202 that in some embodiments, is made of one or more semiconductor materials such as e.g., monocrystalline silicon, silicon germanium, silicon carbide, gallium nitride, gallium arsenide, or other III-V semiconductor material. In one embodiment, substrate 202 has a bulk-semiconductor configuration. In other embodiments, substrate 202 may have an SOI (semiconductor on insulator) configuration. In some embodiments, substrate 202 is formed from a singulated portion of an integrally grown semiconductor material. In other embodiments, portions of substrate 202 may include epitaxially grown semiconductor material. Substrate 202 may also include dielectric structures (e.g., shallow trench isolation structures, buried oxide layers (not shown)).

Figure 2 shows substrate 202 after the formation of P well 212 and N-type well 214. In one embodiment P well 212 is formed by the implantation of P-type dopants (e.g., Boron) into substrate 202 at an energy of 40-500 keV and at a concentration of 2e12-3e13 per cm². N well 214 is formed by the implantation ofN-type dopants (e.g., Arsenic, Phosphorus) into substrate 202 at an energy of 50-700 keV and at a concentration of 2e12-3e13 per cm². However, these implantation operations may be performed at other energies and/or other concentrations in other embodiments.

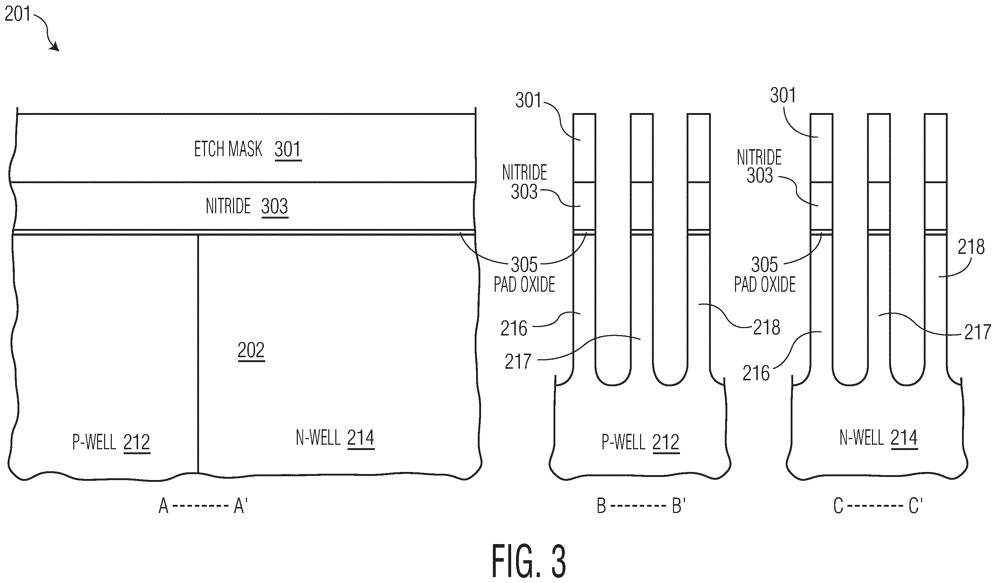

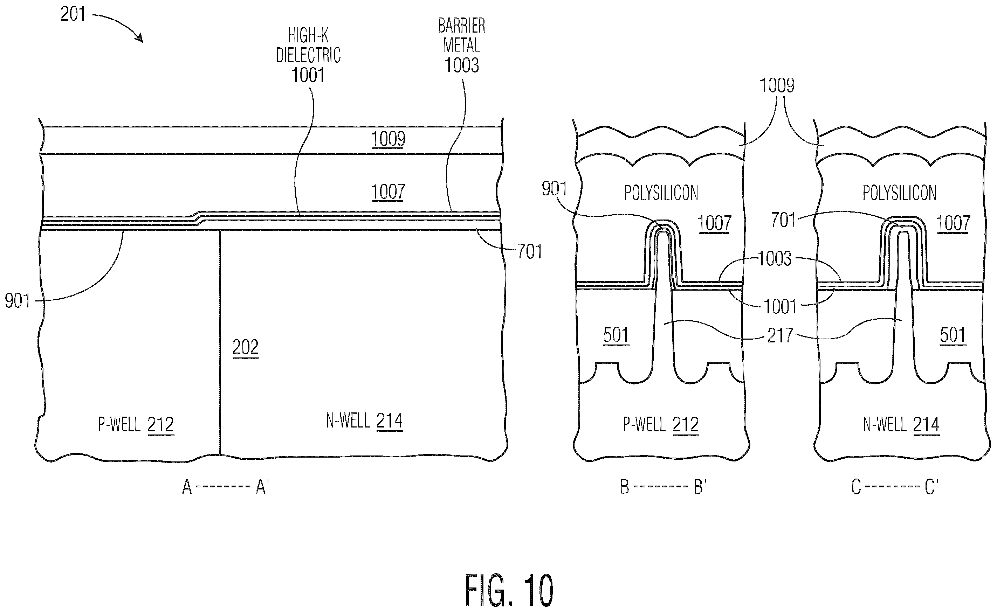

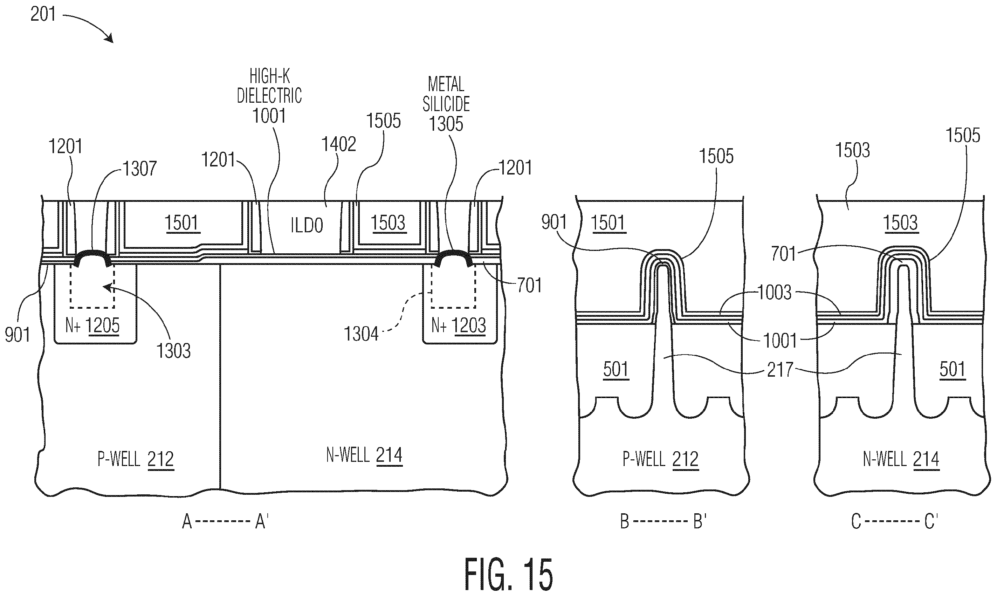

Figure 2 shows the locations of subsequent structures to be formed on wafer 201. Location 207 is where a gate will be subsequently formed and location 209 is the location where a field plate will be subsequently formed. See gate 1501 and field plate 1503 in Figure 15. Figure 2 also shows locations where fins 215-219 will be formed in substrate 202 with fins 216-218 being shown in Figure 3. Figure 2 also shows the area 205 where some of the subsequently formed fins (215, 217, and 219) will be covered with a thin gate dielectric structure (layers 901 and 1001 in Figure 10) and area 205 where some of the subsequently formed fins with a thick gate dielectric structure (layers 701 and 1001 in Figure 10).

Figure 2 shows the locations of three partial cross section views shown in Figures 3-16. Cross section view A-A' is located along subsequently formed fin 217. Cross section view B-B' is located in location 207 orthogonally to the cross section view A-A' and cross section view C-C' is located in location 209 orthogonally to cross section view A-A'.

Figure 3 shows cross sectional views of wafer 201 during a stage of its manufacture subsequent to the stage of Figure 2. As shown in Figure 3, a pad oxide layer 305, a low stress nitride layer 303, and a patterned etch mask 301 are formed on wafer 201. In some embodiments, layer 305 has a thickness of 10 nm and layer 303 has a thickness of 400 nm, but these layers may have other thicknesses in other embodiments. Patterned etch mask 301 is patterned by a photolithographic process and is used to form semiconductor fins (216-218) in substrate 202. In one embodiment, the fins are formed by an anisotropic etch of layers 303 and 305 and a timed anisotropic etch of substrate 202 where the amount of time defines the depth of the etch. As shown in Figure 3, fins 216-218 have a net P-type conductivity doping in cross section B-B' and have a net N-type conductivity doping in cross section C-C'.

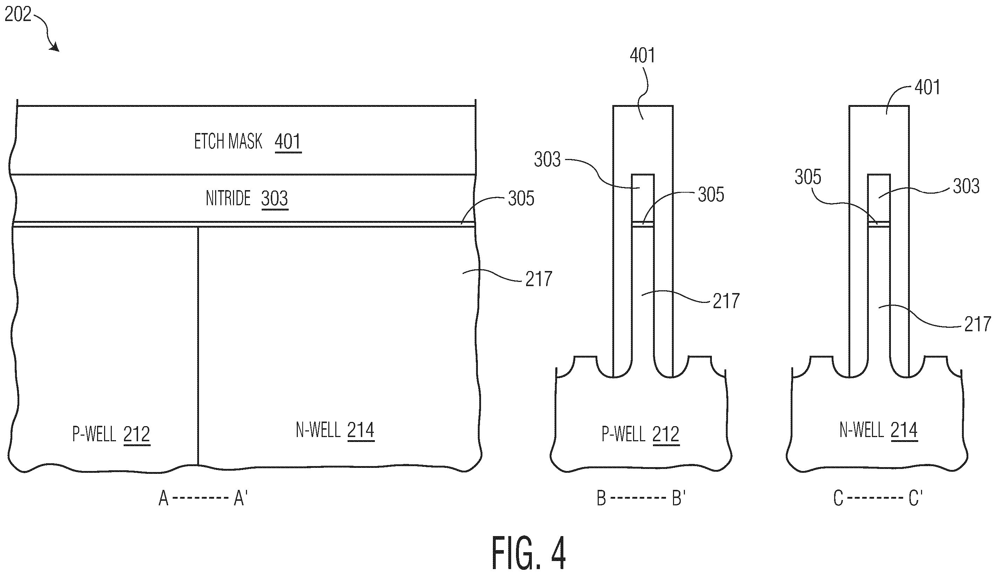

Figure 4 shows cross sectional views of wafer 201 during a subsequent stage of its manufacture where etch mask 301 is removed and a second etch mask 401 is formed by a photolithographic process. Mask 401 is used to remove fins 216 and 218 leaving fin 217. In one embodiment, fins 216 and 218 are removed by an isotropic etch process. In other embodiments, fins 216 and 218 would not be formed from the etching of substrate 202 using mask 301 (see Figure 3). In such embodiments, etch mask 401 would not be needed.

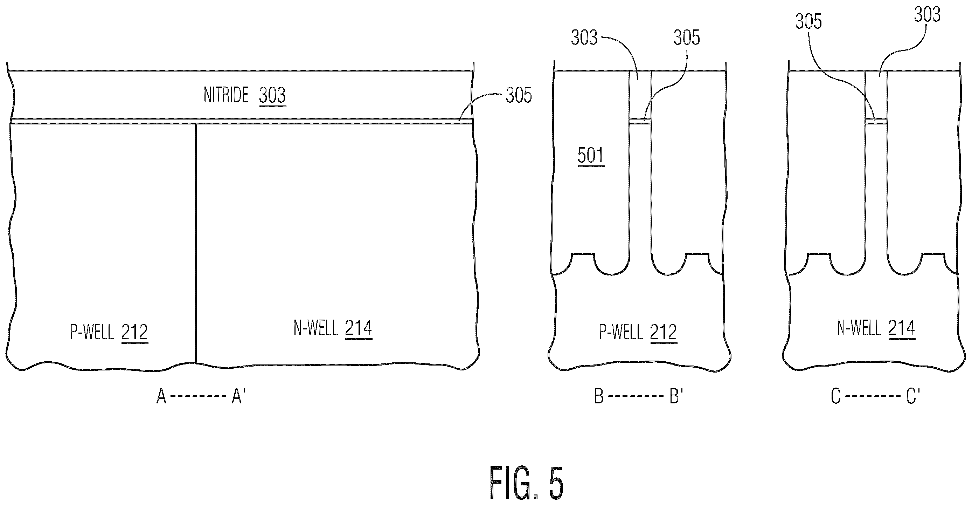

Figure 5 shows cross sectional views of wafer 201 during a subsequent stage of its manufacture where mask 401 is removed from wafer 201. A small layer of oxide is grown on the exposed semiconductor surfaces to remove etch damaged silicon (or other semiconductor material in other embodiments). A layer 501 of oxide is then deposited on wafer 201. Afterwards wafer 201 is planarized (e.g., with a CMP process) using nitride layer 303 as a stop layer.

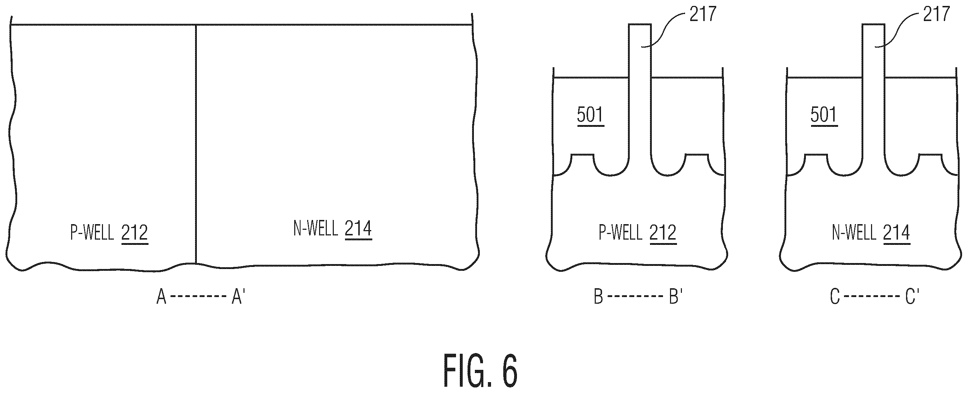

Figure 6 shows cross sectional views of wafer 201 during a subsequent stage of its manufacture where oxide layer 501 is subject to a timed etch to remove a portion of oxide layer 501 to expose a portion of fin 217. Afterwards, nitride layer 303 and layer 305 are removed with etches of appropriate etch chemistries.

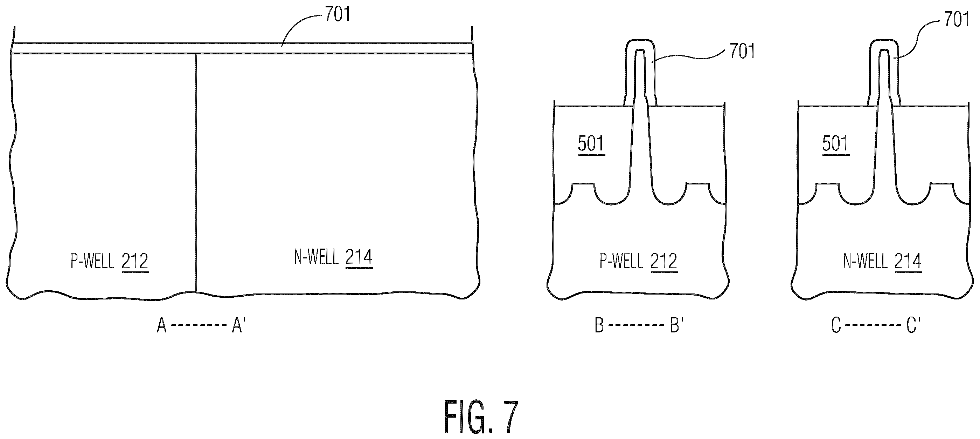

Figure 7 shows cross sectional views of wafer 201 during a subsequent stage of its manufacture where oxide layer 701 is thermally grown on the exposed silicon surfaces. In one embodiment, layer 701 has a thickness in the range of 2-8 nm, but may be of other thicknesses in other embodiments. Prior to forming layer 701, the exposed semiconductor surfaces of substrate 202 are subject to a pre-cleaning treatment. Layer 701 will be used as part of the thicker gate dielectric for the subsequently formed LDMOS transistor.

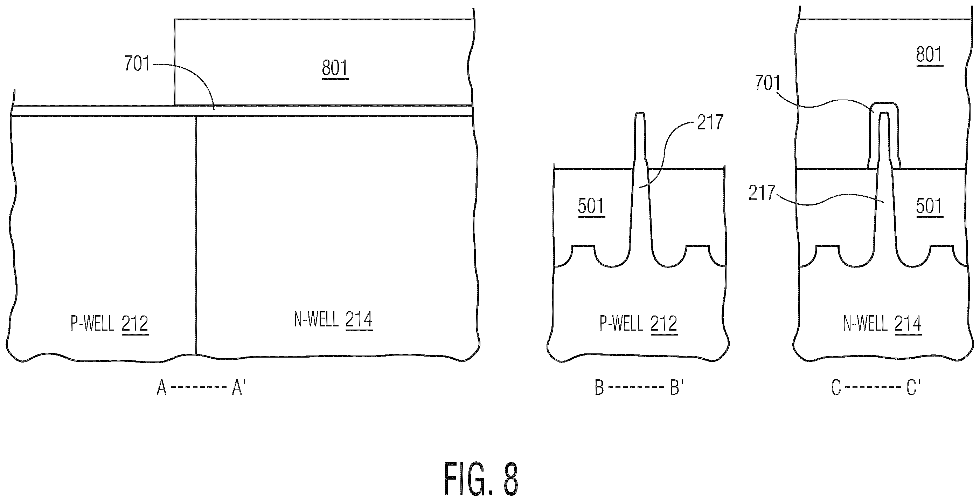

Figure 8 shows cross sectional views of wafer 201 during a subsequent stage of its manufacture where oxide layer 701 is selectively removed from portions of fin 217 (see area 203 of Figure 2) where a thinner gate dielectric will be subsequently formed including over the subsequently formed channel region. Patterned etch mask 801 defines the portions of layer 701 that are selectively removed.

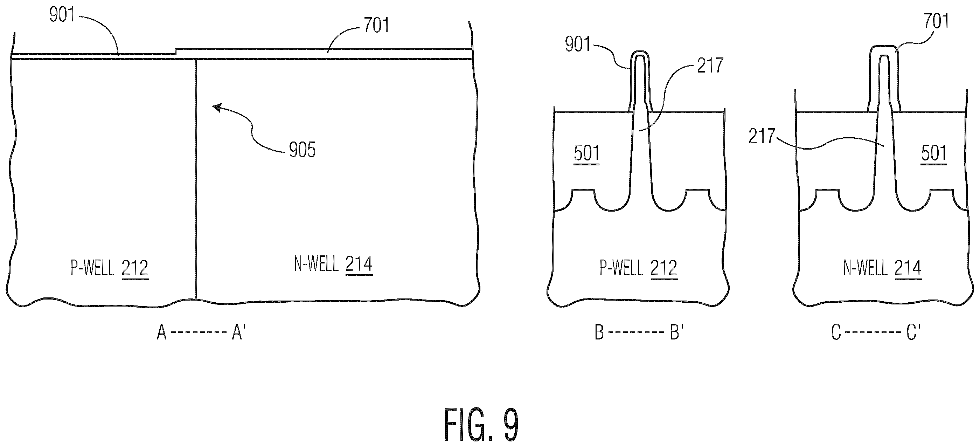

Figure 9 shows cross sectional views of wafer 201 during a subsequent stage of its manufacture where wafer 201 is subject to another oxidation process to form a thinner oxide layer 901 (e.g., of silicon oxide) on the exposed portions of P well 212 in area 203 of wafer 201 (see Figure 2). Oxide layer 901 is thinner than oxide layer 701 such that the gate dielectric that includes oxide layer 901 will be thinner than the gate dielectric that includes oxide layer 701. In one embodiment, layer 901 has a thickness in the range of 5-10Å but may have other thicknesses in other embodiments. Prior to the oxidation process, wafer 201 is subject to a pre-cleaning process.

As shown in Figure 9, the transition region 905 between P well 212 and N well 214 of fin 216 will be covered by a thicker gate dielectric (that includes layer 701) and not the thinner gate dielectric (that includes layer 901). In some embodiments, having the transition region covered by the thicker gate dielectric will enable that region to withstand higher electric fields. As such, this feature may provide for a more reliable transistor that has a higher breakdown voltage at the transition region which is subject to higher electric fields during operation.

Figure 10 shows cross sectional views of wafer 201 during a subsequent stage of its manufacture where additional layers are formed on wafer 201. After the stage of Figure 9, a high K dielectric layer 1001 is deposited on wafer 201. In one embodiment, layer 1001 is made of hafnium dioxide and has a thickness of 1.5-7 nm, but may be made of other high-K dielectric materials and/or have other thicknesses in other embodiments.

In the embodiment shown, thin oxide layer 901 and high-K dielectric layer 1001 form a thin gate dielectric for the subsequently formed transistor and thick oxide layer 701 and high-K dielectric layer 1001 form the thicker gate dielectric layer for the subsequently formed transistor. However, a gate dielectric may have other dielectric layers as well. In some embodiments, the high K dielectric layer is not formed over layer 701.

A barrier metal layer 1003 is then formed over wafer 201. In one embodiment, layer 1003 is made of titanium nitride and has a thickness of 2-10nm, but may be made of other materials and/or be of other thicknesses in other embodiments. Some embodiments may not include a barrier metal layer.

A layer 1007 of polysilicon is formed over wafer 201 followed by a layer 1009 of low stress nitride. In some embodiments, layer 1007 has a thickness in the range of 80-120 nm, but may have other thicknesses in other embodiments. After the stage of Figure 10, wafer 201 is planarized.

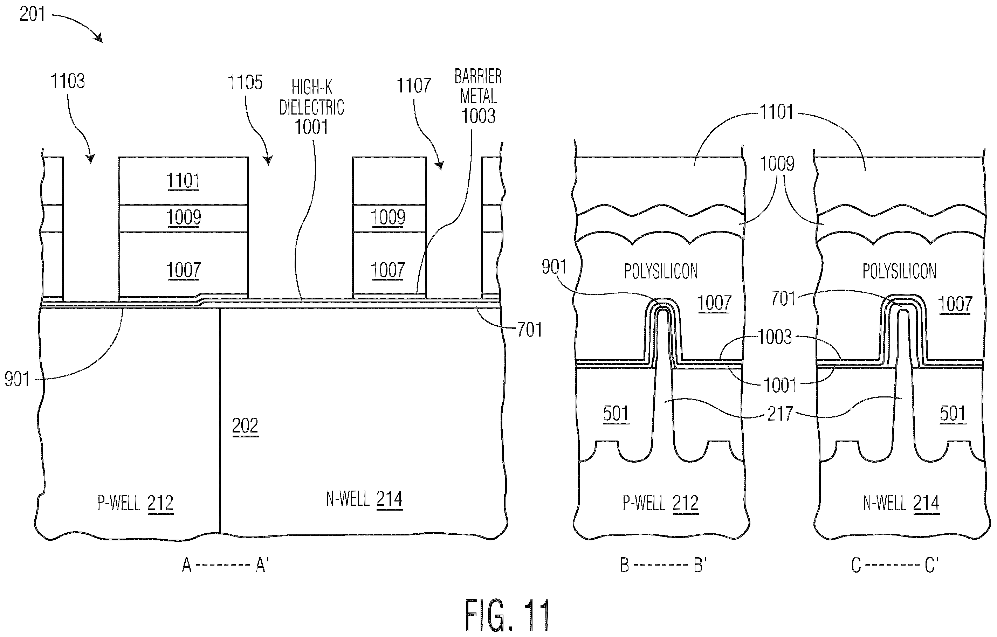

Figure 11 shows cross sectional views of wafer 201 during a subsequent stage of its manufacture where openings 1103, 1105, and 1107 are formed in layers 1009, 1007 and 1003 to expose high K dielectric layer 1001. The openings are formed by etching layers 1009, 1007, and 1003 through an etch mask 1101 patterned by a photolithographic process.

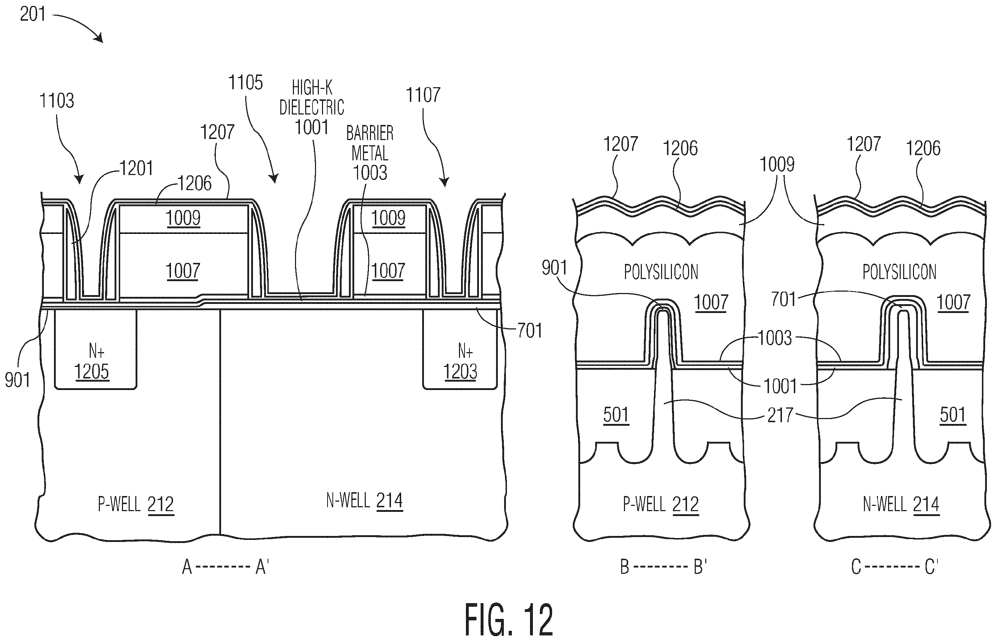

Figure 12 shows cross sectional views of wafer 201 during a subsequent stage of its manufacture where spacers 1201 and N+ regions 1203 and 1205 are formed. After the stage of Figure 11, spacers 1201 are formed in openings 1103, 1105, and 1107. In some embodiments, spacers 1201 are formed by forming a thin layer of nitride followed by a layer of oxide over wafer 201. The oxide and nitride layers are then isotropically etched to form spacers 1201. In one embodiment, the nitride layer has a thickness of 1-9nm, and the oxide layer has a thickness of 2-10nm but these layers may be of other thicknesses in other embodiments. After the formation of spacers 1103, 1105, and 1107, a thin layer 1206 of nitride followed by a thin layer 1207 of oxide are formed over wafer 201.

N+ regions 1205 and 1203 are formed in fin 217 through openings 1103 and 1107, respectively. In one embodiment, regions 1205 and 1203 include a larger extension region of a lighter concentration of N-type dopants and a smaller contact region of a heavier concentration of N-type dopants. In some embodiments, the extension region dopants are implanted at an energy of 0.5-10 keV and at a concentration of 1e14-1e15 per cm², and the contact region dopants are implanted at an energy of 3-40 keV and at a concentration of 1e15-3e15 per cm², but these regions may be implanted at other energies and/or other concentrations in other embodiments. In some embodiments, regions 1203 and 1205 are formed with at least one mask (not shown). In some embodiments, regions 1205 and 1203 do not include extension regions. Also in some embodiments, the extension regions may be implanted prior to the formation of spacers 1201. In some embodiments where P-type LDMOS transistors are formed on wafer 201, P+ contact regions (not shown) similar to regions 1205 and 1203 may be formed in fins in other areas of wafer 201 by similar ion implantation operations where P-type dopants are implanted instead of N-type dopants.

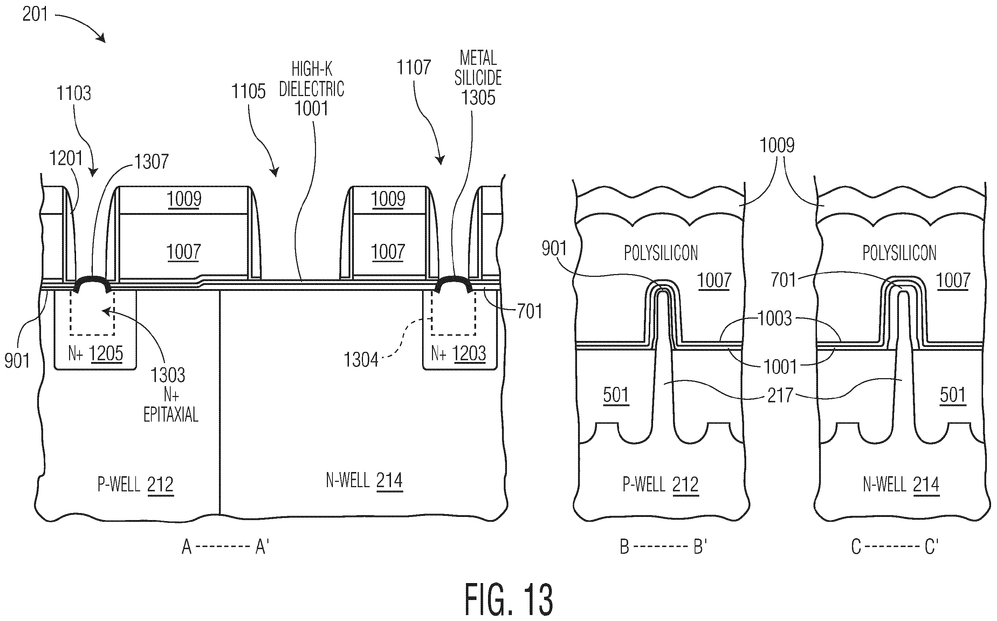

Figure 13 shows cross sectional views of wafer 201 after N+ epitaxial regions 1303 and 1304 are formed on wafer 201. Regions 1303 and 1304 are formed by etching a portion of region 1205 and 1203 of fin 217 through a mask (not shown) to create openings in fin 217 at those locations. Afterwards, N-type epitaxial silicon (regions 1303 and 1304) are grown in the openings and laterally outside the openings (into and out of the page in the view of cross section A-A' of Figure 13) to increase the area of the N+ regions of the fin for subsequently formed source and drain contacts. In some embodiments, portions of other fins may be removed in a similar manner to increase the size of the P+ contact regions for P-type LDMOS transistors (not shown). Afterwards, wafer 201 is annealed to activate the dopants.

A thin metal film (e.g., tungsten, cobalt- not shown in Figure 13) is then formed over wafer 201. Wafer 201 is then heated to form silicides 1307 and 1305 on regions 1303 and 1304 respectively. The unreacted metal is then removed.

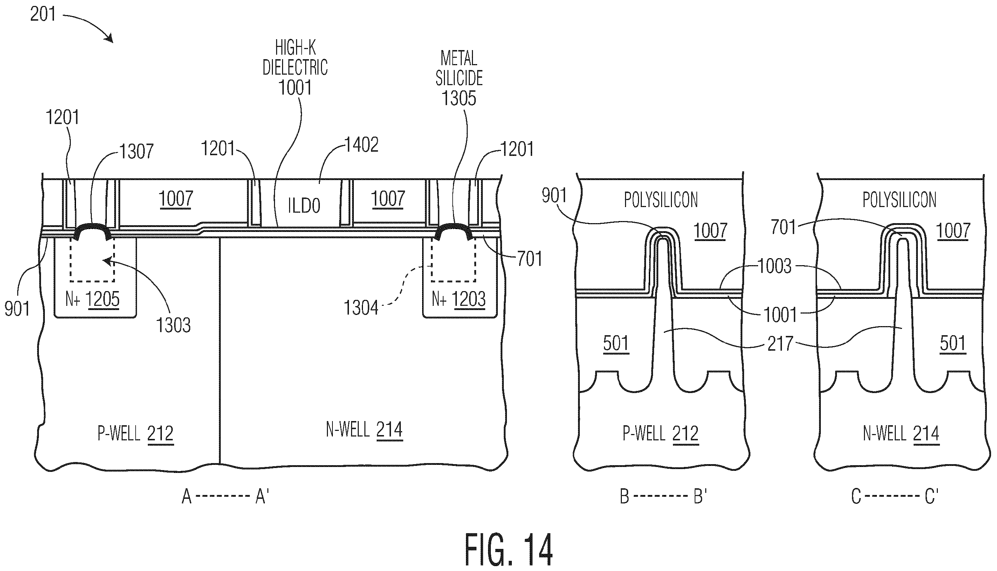

Figure 14 shows cross sectional views of wafer 201 after the formation interlayer dielectric structure 1402 in openings 1103, 1105, and 1107, respectfully. In some embodiments, structure 1402 is formed by depositing a layer of interlayer dielectric material (e.g., an oxide formed by a TEOS process) on wafer 201 and then planarizing wafer 201 to remove nitride layer 1009, portions of polysilicon layer 1007, and portions of the inter layer dielectric material.

Figure 15 shows cross sectional views of wafer 201 after the remaining portions of polysilicon layer 1007 have been removed and metal gate 1501 and field plate 1503 have been formed in their place. In some embodiments, the remaining portions of polysilicon layer 1007 are removed by etching wafer 201. A layer of work function metal 1505 is selectively formed in regions of the N-type devices. In one embodiment, layer 1505 may be made of aluminum and has a thickness of 2 nm, but may be made of other materials and have other thicknesses in other embodiments. Layer 1505 is designed to set the threshold voltages of the N-type transistors. A different layer (not shown) of work function material may be selectively formed over areas of wafer 201 to set the work function for the P-type devices.

Afterwards, a layer of gate metal (e.g., tungsten) is formed over wafer 201. Wafer 201 is planarized using dielectric structure 1402 as an etch stop to form gate 1501 and field plate 1503 where both structures include a portion of layer 1505. In other embodiments, the gates and field plates may be polysilicon instead of metal.

Referring back to Figure 2, gate 1501 and field plate 1503 are located in location 207 and location 209 respectfully. As shown in Figure 2, gate location 207 and field plate location 209 are located over multiple fins (fins 215, 217, and 219) that remain after the stage of Figure 4. Accordingly, fins 215 and 219 also include source regions, channel regions, drift region, and drain regions (not shown). In some embodiments, the source regions of each fin would be electrically connected together and the drain regions of each fin would be electrically connected together.

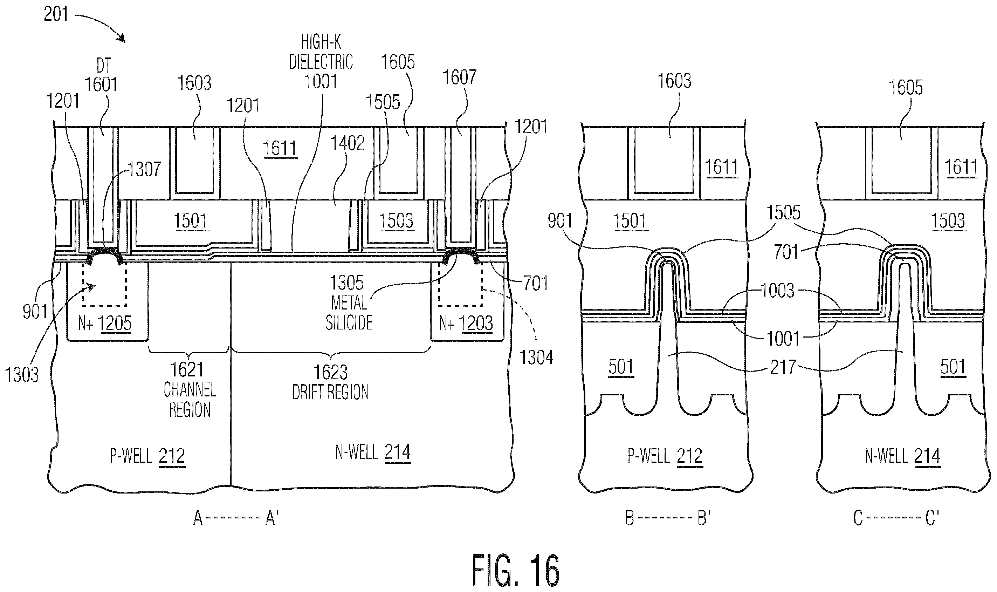

Figure 16 shows cross sectional views of wafer 201 after gate contact 1603 is formed to electrically contact gate 1501, field contact 1605 is formed to electrically contact field plate 1503, source contact is formed to electrically contact source silicide 1307 and drain contact 1607 is formed to electrically contact drain silicide 1305. Each of contacts 1601, 1603, 1605, and 1607 include a portion of a seed layer 1609. In some embodiments, the contacts are made of a metal such tungsten, tungsten nitride, or copper, but may be made of other metals in other embodiments.

In some embodiments, the contacts 1601, 1603, 1605, and 1607 are made by forming a layer 1611 of interlevel dielectric material over wafer 201. In some embodiments, layer 1611 is made of an oxide formed by a TEOS process. Openings are formed in layer 1611 (with one or more masks) to expose source silicide 1307, gate 1501, field plate 1503, and drain silicide 1305. After the deposition of seed layer 1609, a layer of contact metal is formed on wafer 201. Afterwards, wafer 201 is planarized to form the individual contacts.

As shown in Figure 16, gate 1501 covers the channel region 1621 of the transistor that is located in semiconductor fin 217 as well as a portion of the drift region 1623. The channel region 1621 at cross section B-B' is covered by a thinner gate dielectric (made of layer 901 and layer 1001). The drift region 1623 at the cross section C-C' is covered by a thicker gate dielectric (made of layer 701 and layer 1001). As shown, gate 1501 is located directly over channel region 1621 and a portion of drift region 1623 and directly lateral to opposing sidewalls of these regions.

As shown in Figure 16, an N-type LDMOS transistor includes a drain region (that includes regions 1303 and 1205), a channel region 1621 in fin 217, a drift region 1623 in fin 217, a source region (that includes regions 1304 and 1203), a gate 1501, and a field plate 1503. The transistor includes a carrier path from the source region through channel region 1621, through drift region 1623, to the drain region.

After the stage of Figure 16, one or more additional interconnect layers (not shown) are formed over wafer 201 where the one or more interconnect layers include conductive interconnects and vias separated by interlevel dielectric material. The conductive interconnects and vias are electrically connected to devices formed in the substrate. Afterwards, external die terminals (e.g., bond pads, posts, pillars) are then formed on wafer 201 and are electrically connected to conductive interconnect structures of the interconnect layers. Wafer 201 is then singulated into multiple integrated circuits. Each integrated circuit includes one or more transistors as shown and described in the Figures above. Some integrated circuits may include P-type LDMOS transistors as well. The integrated circuits are then packaged to form packaged integrated circuits that are implemented in electronic systems such as e.g., TVs, computers, cell phones, appliances, automobiles, manufacturing equipment, or communications equipment.

Although an N-type LDMOS is shown as being made by the processes described above, P-type transistors with drift regions may be made by similar processes with the net conductivity dopants of the regions switched.

Transistors of other embodiments may have different structures, be made of different materials, and/or be formed by different process. As explained above, an integrated circuit may include both N-type and P-type transistors. In some embodiments, the transistors would not include a field plate. In some embodiments, the field plate and a gate would be independently biased. In some embodiments providing an independently biased field plate located directly over a thicker gate dielectric may provide for improved reliability without degrading RF performance. In other embodiments, the field plate and source would be electrically connected together. In some embodiments, the transistors would include dummy gates.

In some embodiments, the LDMOS transistor described above may be used in an RF power amplifier. In simulations of some embodiments, such a transistor may have a breakdown voltage of greater than 10 V and a cutoff frequency (Ft) of greater than 40 GHz, which may exceed the performance of other existing LDMOS transistor designs implemented in a semiconductor fin using FinFET processes. In some embodiments, such transistor may eliminate the need for separate cascode devices in a power amplifier circuit. Accordingly, the circuit may require 40% less area and deliver 2 dB more output power than other conventional circuits. In other embodiments, the LDMOS transistor may be used in a power converter such as a DC to DC power converter.

In some embodiments, utilizing a thinner gate dielectric for covering at least a portion of the channel region may provide for a shorter channel length to improve both DC and RF performance such as providing for a lower on resistance and a higher cut off frequency. In some embodiments, providing a thicker gate dielectric over the drift region under the gate may provide for improved drain to gate breakdown voltages thereby improving reliability. In some embodiments providing a separately biased field plate located directly over a thicker gate dielectric may provide for improved reliability by reducing hot carrier injection without degrading RF performance. Also, covering the channel-drift interface transition region 905 with a thicker gate dielectric may improve hot carrier degradation at this location to increase transistor reliability.

As disclosed herein, a first structure is "directly over" a second structure if the first structure is located over the second structure in a line having a direction that is perpendicular with a generally planar major side of the wafer or substrate. For example, in Figure 16, gate contact 1603 is located directly over P well 212. Contact 1605 is not directly over P well 212. As disclosed herein, a first structure is "directly beneath" or "directly under" a second structure if the first structure is located beneath the second structure in a line having a direction that is perpendicular with a generally planar major side of the wafer or substrate. For example, in Figure 16, N well 214 is directly beneath contact 1607. P well 212 is not directly beneath contact 1607. One structure is "directly between" two other structures in a line if the two structures are located on opposite sides of the one structure in the line. For example, in Figure 16, contact 1603 is located directly between contact 1601 and contact 1605 in a line in the cut away side view of cross section A-A' of Figure 16. N well 214 is not located directly between contacts 1603 and 1605 in a line. A first structure is "directly lateral" to a second structure if the first structure and second structure are located in a line having a direction that is parallel with a generally planar major side of the wafer or substrate. For example, in Figure 16, contacts 1601 and 1605 are directly lateral to each other. One structure is "directly laterally between" two other structures if the two structures are located on opposite sides of the one structure in a line that is parallel with a generally planar major side of the wafer or substrate. For example, in Figure 16, contact 1603 is located directly laterally between contact 1601 and 1605. A surface is at a "higher elevation" than another surface if that surface is located closer to the top of the active side of a wafer or integrated circuit in a line having a direction that is perpendicular with the generally planar major side of the wafer or integrated circuit. In the view of Figure 16, the active side of wafer 201 is the top side in Figure 16. For example, contact 1603 is at a higher elevation than field plate 1503. As used herein, a first structure having thickness designed to be greater than a thickness of a second structure means that the thickness of the first structure is greater at least in part due to specified manufacturing process parameters and not due solely to unintentional variations in manufacturing parameters.

In one embodiment, a transistor includes a drain region being of a first net conductivity doping type; a source region being of the first net conductivity doping type; a channel region located in a semiconductor fin in a carrier path between the drain region and the source region, the channel region being of a second net conductivity doping type opposite the first net conductivity doping type; a drift region located in the semiconductor fin being of the first net conductivity doping type, the drift region located in the carrier path between the channel region and the drain region; a gate located directly over a first portion of the semiconductor fin and directly lateral to opposing sidewalls of the first portion of the semiconductor fin; a first gate dielectric structure of a first thickness including a portion located directly over of a first portion of the channel region and directly laterally to opposing sidewalls of the first portion of the channel region, the first portion of the channel region being located in the first portion of the semiconductor fin directly under the gate; a second gate dielectric structure of a second thickness including a portion located directly over a first portion of the drift region and directly lateral to opposing sidewalls of the first portion of the drift region, the first portion of the drift region being located in the first portion of the semiconductor fin directly under the gate, the second thickness is of a thickness designed to be greater than the first thickness.

In a further embodiment, the semiconductor fin includes a transition region between the channel region and the drift region, the second gate dielectric structure is located directly over the transition region and directly lateral to opposing sides of the transition region.

In a further embodiment, a field plate that is physically noncontiguous with the gate, the field plate is located over a second portion of the semiconductor fin and directly lateral to opposing sidewalls of the second portion of the semiconductor fin, wherein the second gate dielectric structure is located directly between the second portion of the semiconductor fin and the field plate.

In a further embodiment, the field plate characterized as a metal field plate.

In a further embodiment, the first gate dielectric structure includes a high K dielectric material.

In a further embodiment, the first gate dielectric structure and the second gate dielectric structure each include an oxide of semiconductor material of the semiconductor fin.

In a further embodiment, the drain region and the source region each include an epitaxially grown semiconductor material including at least a portion located in the semiconductor fin.

In a further embodiment, the gate is characterized as a metal gate.

In a further embodiment, the semiconductor fin is located on an integrated circuit; the integrated circuit includes a second semiconductor fin, the semiconductor fin and the second semiconductor fin each extending in a first lateral direction generally parallel to each other; the gate is located directly over a first portion of the second semiconductor fin and directly laterally to opposing sidewalls of the first portion of the second semiconductor fin, the first portion of the second semiconductor fin including a second channel region and a portion of a second drift region.

In a further embodiment, the second gate dielectric structure includes a portion located directly over a second portion of the channel region and directly lateral to opposing sidewalls of the second portion of the channel region, the gate is located directly over the second portion of the channel region.

In another embodiment, a method includes forming a channel region and a drift region in a semiconductor fin, the channel region and the drift region are located in a carrier path between a source region and a drain region, the channel region is located in the carrier path between the source region and the drift region, the drift region is located in the carrier path between the channel region and the drain region, the drift region, the drain region, and the source region are of a first net conductivity dopant type and the channel region is of a second net conductivity dopant type opposite the first net conductivity dopant type; forming a first gate dielectric structure directly over a first portion of the channel region and directly lateral to opposing sidewalls of the first portion of the channel region; forming a second gate dielectric structure directly over the drift region and directly lateral to opposing to sidewalls of the drift region, the second gate dielectric structure having a thickness that is designed to be greater than a thickness of the first gate dielectric structure; forming a gate directly over a first portion of the first gate dielectric structure and directly lateral to sidewalls of the first portion of the first gate dielectric structure and directly over a first portion of the second gate dielectric structure over and directly lateral to opposing sidewalls of the first portion of the second gate dielectric structure, wherein the gate is located directly over a first portion of the drift region.

In a further embodiment, the forming the second gate dielectric structure includes forming the second gate dielectric structure directly over a second portion of the channel region and directly lateral to opposing to sidewalls of the second portion of the channel region, wherein the gate is located directly over the second portion of the channel region.

In a further embodiment, the semiconductor fin includes a transition region between the channel region and the drift region, the transition region is located directly under the second gate dielectric structure.

A further embodiment includes forming a field plate directly over a second portion of the second gate dielectric structure and directly lateral to opposing sidewalls of the second portion of the second gate dielectric structure, wherein the second portion of the second gate dielectric structure is located directly over a second portion of the drift region and directly lateral to opposing sidewalls of the second portion of the drift region.

In a further embodiment, the first gate dielectric structure includes a high K dielectric material.

In a further embodiment, the forming the first gate dielectric structure includes oxidizing material of the semiconductor fin at a location of the first portion of the channel region.

In a further embodiment, the forming the second gate dielectric structure includes oxidizing material of the semiconductor fin at a location of the drift region.

In a further embodiment, the forming the drain region includes removing material of the semiconductor fin at a location of the drain region and epitaxially growing semiconductor material on the semiconductor fin at the location of the drain region; the forming the source region includes removing material of the semiconductor fin at a location of the source region and epitaxially growing semiconductor material on the semiconductor fin at the location of the source region.

In a further embodiment, the semiconductor fin is located on a wafer, wherein the wafer includes a second semiconductor fin, the semiconductor fin and the second semiconductor fin each extending in a first lateral direction generally parallel with each other; the forming the gate includes forming the gate directly over a second channel region located in the second semiconductor fin and directly over a first portion of a second drift region located in the second semiconductor fin; a third gate dielectric structure is formed directly over a first portion of the second channel region and directly lateral to opposing sidewalls of the first portion of the second channel region; a fourth gate dielectric structure is formed directly over the second drift region and directly lateral to opposing to sidewalls of the second drift region, the fourth gate dielectric structure is of a thickness designed to be greater than a thickness of the third gate dielectric structure; the gate is located directly over a portion of the third gate dielectric structure and directly over a portion of the fourth gate dielectric structure; the method further includes singulating the wafer into multiple integrated circuits, wherein an integrated circuit includes the semiconductor fin and the second semiconductor fin.

In a further embodiment, the forming the gate includes: forming a sacrificial polysilicon gate; removing the sacrificial polysilicon gate; forming a metal gate in a location of the removed polysilicon gate.

Features specifically shown or described with respect to one embodiment set forth herein may be implemented in other embodiments set forth herein.

While particular embodiments of the present invention have been shown and described, it will be recognized to those skilled in the art that, based upon the teachings herein, further changes and modifications may be made without departing from this invention and its broader aspects, and thus, the appended claims are to encompass within their scope all such changes and modifications as are within the scope of this invention.

## Claims

1. A transistor comprising:
a drain region being of a first net conductivity doping type;
a source region being of the first net conductivity doping type;
a channel region located in a semiconductor fin in a carrier path between the drain region and the source region, the channel region being of a second net conductivity doping type opposite the first net conductivity doping type;
a drift region located in the semiconductor fin being of the first net conductivity doping type, the drift region located in the carrier path between the channel region and the drain region;
a gate located directly over a first portion of the semiconductor fin and directly lateral to opposing sidewalls of the first portion of the semiconductor fin;
a first gate dielectric structure of a first thickness including a portion located directly over of a first portion of the channel region and directly laterally to opposing sidewalls of the first portion of the channel region, the first portion of the channel region being located in the first portion of the semiconductor fin directly under the gate;
a second gate dielectric structure of a second thickness including a portion located directly over a first portion of the drift region and directly lateral to opposing sidewalls of the first portion of the drift region, the first portion of the drift region being located in the first portion of the semiconductor fin directly under the gate, the second thickness is of a thickness designed to be greater than the first thickness.

2. The transistor of claim 1 wherein the semiconductor fin includes a transition region between the channel region and the drift region, the second gate dielectric structure is located directly over the transition region and directly lateral to opposing sides of the transition region.

3. The transistor of claim 1or claim 2 further comprising:
a field plate that is physically noncontiguous with the gate, the field plate is located over a second portion of the semiconductor fin and directly lateral to opposing sidewalls of the second portion of the semiconductor fin, wherein the second gate dielectric structure is located directly between the second portion of the semiconductor fin and the field plate.

4. The transistor of claim 3 wherein the field plate characterized as a metal field plate.

5. The transistor according to any preceding claimwherein the first gate dielectric structure includes a high K dielectric material.

6. The transistor according to any preceding claim wherein the first gate dielectric structure and the second gate dielectric structure each include an oxide of semiconductor material of the semiconductor fin.

7. The transistor according to any preceding claim wherein the drain region and the source region each include an epitaxially grown semiconductor material including at least a portion located in the semiconductor fin.

8. The transistor according to any preceding claim wherein the gate is characterized as a metal gate.

9. The transistor according to any preceding claim wherein:
the semiconductor fin is located on an integrated circuit;
the integrated circuit includes a second semiconductor fin, the semiconductor fin and the second semiconductor fin each extending in a first lateral direction generally parallel to each other;
the gate is located directly over a first portion of the second semiconductor fin and directly laterally to opposing sidewalls of the first portion of the second semiconductor fin, the first portion of the second semiconductor fin including a second channel region and a portion of a second drift region.

10. The transistor according to any preceding claim wherein the second gate dielectric structure includes a portion located directly over a second portion of the channel region and directly lateral to opposing sidewalls of the second portion of the channel region, the gate is located directly over the second portion of the channel region.

11. A method comprising:
forming a channel region and a drift region in a semiconductor fin, the channel region and the drift region are located in a carrier path between a source region and a drain region, the channel region is located in the carrier path between the source region and the drift region, the drift region is located in the carrier path between the channel region and the drain region, the drift region, the drain region, and the source region are of a first net conductivity dopant type and the channel region is of a second net conductivity dopant type opposite the first net conductivity dopant type;
forming a first gate dielectric structure directly over a first portion of the channel region and directly lateral to opposing sidewalls of the first portion of the channel region;
forming a second gate dielectric structure directly over the drift region and directly lateral to opposing to sidewalls of the drift region, the second gate dielectric structure having a thickness that is designed to be greater than a thickness of the first gate dielectric structure;
forming a gate directly over a first portion of the first gate dielectric structure and directly lateral to sidewalls of the first portion of the first gate dielectric structure and directly over a first portion of the second gate dielectric structure over and directly lateral to opposing sidewalls of the first portion of the second gate dielectric structure, wherein the gate is located directly over a first portion of the drift region.

12. The method of claim 11 wherein the forming the second gate dielectric structure includes forming the second gate dielectric structure directly over a second portion of the channel region and directly lateral to opposing to sidewalls of the second portion of the channel region, wherein the gate is located directly over the second portion of the channel region.

13. The method of claim 11 or claim 12 wherein the semiconductor fin includes a transition region between the channel region and the drift region, the transition region is located directly under the second gate dielectric structure.

14. The method according to any of claims 11 to 13 further comprising forming a field plate directly over a second portion of the second gate dielectric structure and directly lateral to opposing sidewalls of the second portion of the second gate dielectric structure, wherein the second portion of the second gate dielectric structure is located directly over a second portion of the drift region and directly lateral to opposing sidewalls of the second portion of the drift region.

15. The method according to any of claims 11 to 14 wherein the first gate dielectric structure includes a high K dielectric material.
